# EUROPEAN PATENT SPECIFICATION

(11) **EP 3 462 508 B1**
(45) Date of publication and mention of the grant of the patent: **12.08.2020**
(21) Application number: 18197797.6
(22) Date of filing: 28.09.2018
(51) Int. Cl.: H01L 49/02, H01G 4/30, H01G 4/33, H01G 2/22, H01G 4/14, H01G 4/252

(54) **HIGH-VOLTAGE CAPACITOR, SYSTEM INCLUDING THE CAPACITOR, AND METHOD FOR MANUFACTURING THE CAPACITOR**
HOCHSPANNUNGSKONDENSATOR, SYSTEM MIT DEM KONDENSATOR UND VERFAHREN ZUR HERSTELLUNG DES KONDENSATORS
CONDENSATEUR À HAUTE TENSION, SYSTÈME COMPRENANT LE CONDENSATEUR ET PROCÉDÉ DE FABRICATION DU CONDENSATEUR

(30) Priority: 28.09.2017 IT 201700108913
(43) Date of publication of application: 03.04.2019
(73) Proprietor: STMicroelectronics S.r.l., 20864 Agrate Brianza (MB) (IT)
(72) Inventor: PATTI, Davide Giuseppe, 95030 MASCALUCIA (CT) (IT); VALVO, Giuseppina, 95123 CATANIA (IT); SANFILIPPO, Delfo Nunziato, 95128 CATANIA (IT)
(74) Representative: Bertolotto, Simone

(56) References cited:
- CN-U- 204 991 474
- US-A1- 2007 109 719

## Description

### TECHNICAL FIELD

The present invention relates to a high-voltage capacitor, to a system including the capacitor, and to a method for manufacturing the capacitor.

### BACKGROUND ART

High-voltage (HV) capacitors for integrated circuits are known, configured for enabling the transmission of signals at high frequencies, for example of the order of megahertz, between conductive elements biased at a very high difference of potential, for example around 10 kV or of the order of tens of kilovolts, and that hence require electrical insulation; see, for example, the document No. US 2016/0133690.

Said HV capacitors typically have dielectric layers of a thickness large enough to present a breakdown voltage higher than the difference of potential at which, in use, its terminals are biased.

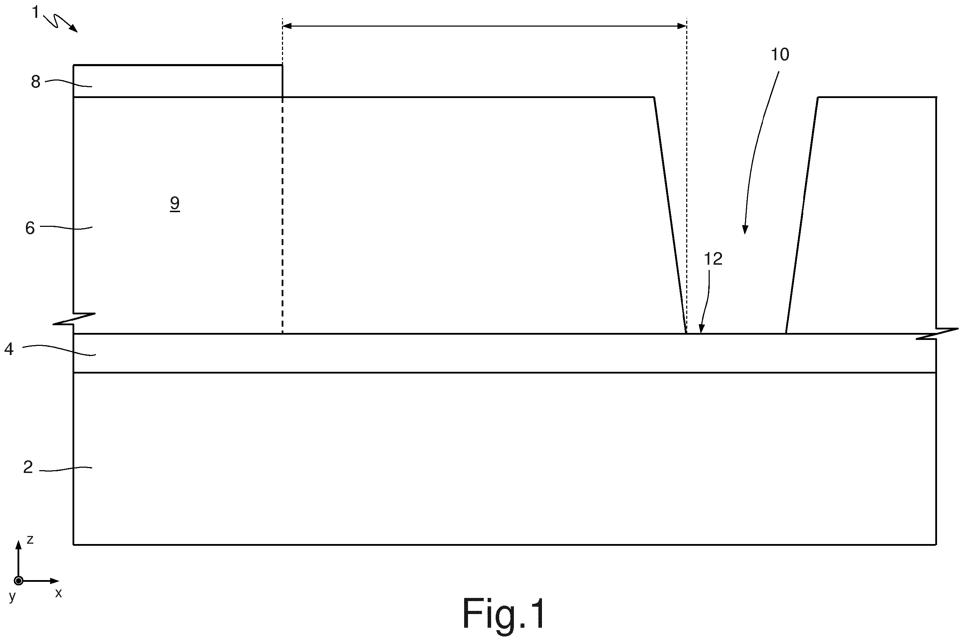

Figure 1 shows, in a triaxial system of orthogonal coordinates x, y, z, a lateral cross-sectional view in the plane xz of a HV capacitor 1 of a known type. The HV capacitor 1 comprises a substrate 2, a bottom electrode 4, which extends over the substrate 2, a dielectric layer 6, which extends over the bottom electrode 4, and a top electrode 8, which extends over the dielectric layer 6. The portion of the dielectric layer 6 set on top, in plan view in the plane xy, of the top electrode 8 and the bottom electrode 4 constitutes the active area 9 of the HV capacitor 1, offering the highest contribution to the capacitance of the HV capacitor 1.

A recess 10 extends throughout the thickness of the dielectric layer 6 so as to expose a contact region 12 of the bottom electrode 4, and hence enable electrical contact of the bottom electrode 4.

The thickness of the dielectric layer 6 is such as to obtain the desired breakdown voltage and is typically in the region of a few tens of micrometres.

The present applicant has found that a further mechanism of breakdown of HV capacitors is due to the accumulation over time of contaminating particles on the top surface of the dielectric layer 6, which may form a surface conductive path between the top electrode 8 and the contact region 12, drastically reducing the lateral surface resistance between the top electrode 8 and the contact region 12 and introducing excessive leakage currents. Moreover, also the presence of humidity on the top surface of the dielectric layer 6 may reduce the surface resistance and favour conductive phenomena. In these conditions, arc short circuits may be set up between edges of the top surface of the dielectric layer 6 (facing the contact region 12) and the contact region 12.

Patent document US2007/109719 relates to an electronic component having a capacitor element.

CN204 991 474 U discloses a high voltage capacitor wherein the exposed dielectric has a surface which is grooved in the area between the first electrode and the contact area of the other electrode to reduce the probability of surface breakdown.

### DISCLOSURE OF INVENTION

The aim of the present invention is to provide a capacitor, a system including the capacitor, and a method for manufacturing the capacitor, designed to overcome the drawbacks of the known art.

According to the present invention a capacitor, a system including the capacitor, and a method for manufacturing the capacitor are provided, as defined in the annexed claims.

### BRIEF DESCRIPTION OF THE DRAWINGS

For a better understanding of the present invention preferred embodiments will now be described, purely by way of non-limiting example, with reference to the attached drawings, wherein:
- Figure 1 is a schematic cross-sectional view of a high-voltage (HV) capacitor according to an embodiment of a known type;
- Figure 2 is a schematic cross-sectional view of a HV capacitor according to an embodiment of the present invention;
- Figure 3 is a schematic cross-sectional view of a HV capacitor according to another embodiment of the present invention;
- Figure 4 is a schematic cross-sectional view of a HV capacitor according to a further embodiment of the present invention;
- Figures 5A-5F show a method for manufacturing the HV capacitor of Figure 4; and
- Figure 6 shows a block diagram of an electronic system including a HV capacitor according to any one of the embodiments of the present invention.

### BEST MODE FOR CARRYING OUT THE INVENTION

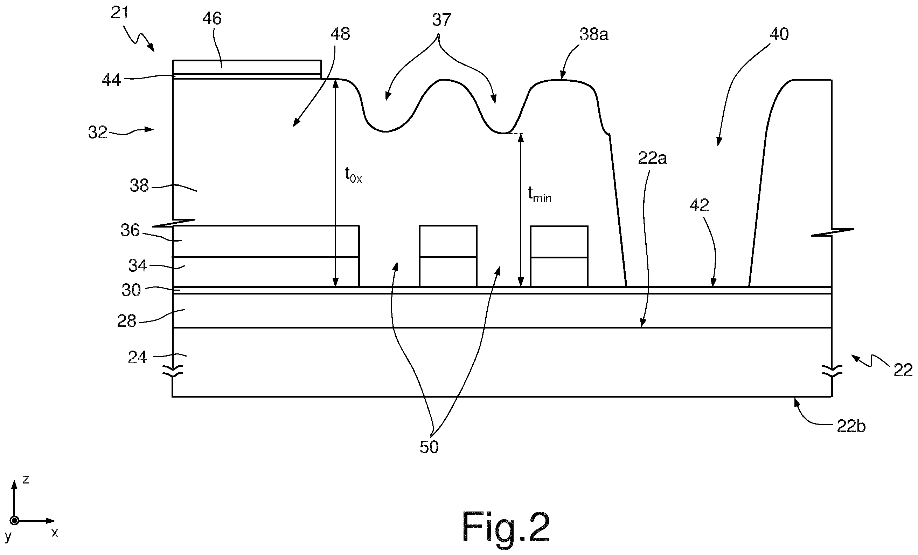

Figure 2 shows, in a triaxial system of orthogonal coordinates x, y, z, a lateral cross-sectional view in the plane xz of a capacitor 21. In particular, the capacitor 21 is of a type for use in high voltage or extra-high voltage applications (referred to hereinafter also generically as HV). In this context, by "high voltage" or "extra-high voltage" are meant voltages ranging between 5 000 V and 20 000 V.

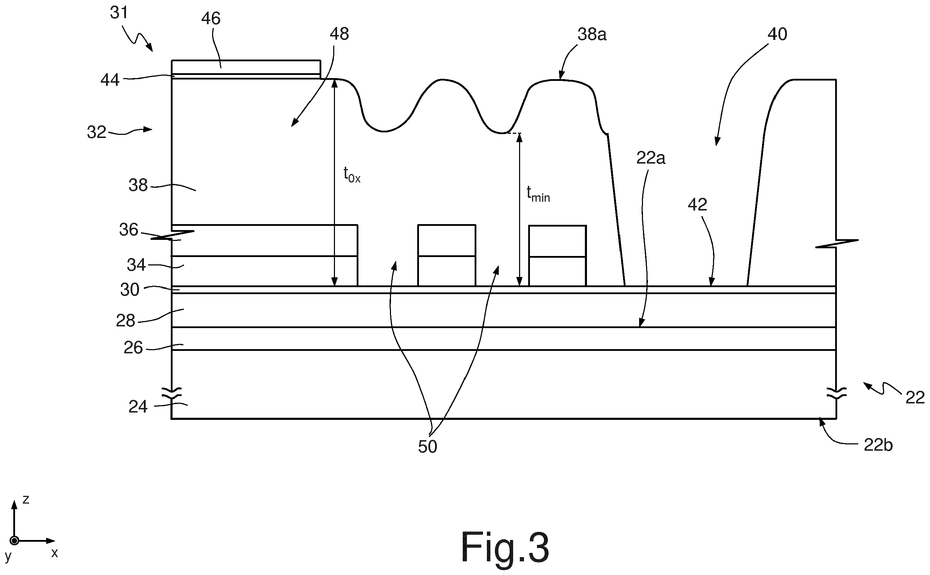

The HV capacitor 21 comprises a substrate 22, which extends between a front surface 22a thereof (parallel to the plane xy) and a rear surface 22b thereof (parallel to the plane xy). In the embodiment of Figure 2, the substrate 22 is made of insulating material, such as silicon dioxide (SiO₂), having a thickness, for example, ranging between 0.5 µm and 2 µm, in particular 0.7 µm (which can be deposited on a substrate, for example, made of high-resistivity silicon). Figure 3 shows a HV capacitor 31 according to a further embodiment. The HV capacitor 31 differs from the HV capacitor 21 exclusively as regards the material of the substrate 22. The substrate 22 of the HV capacitor 31 comprises a high-resistivity substrate 24 and a field plate oxide layer 26, which extends over the high-resistivity substrate 24. The high-resistivity substrate is, for example, made of polysilicon or silicon with high electrical resistivity, for example higher than 1000 Ω·cm, and has a thickness ranging between 100 µm and 500 µm, in particular 280 µm. The field plate oxide layer 26 is, for example, made of silicon dioxide and has a thickness ranging between 0.5 µm and 2 µm, in particular 0.7 µm.

The HV capacitor 21 of Figure 2 further comprises a bottom electrode 28, which extends over the substrate 22. The bottom electrode 28 is made of conductive material, such as aluminium or copper and has a thickness, for example, ranging between 0.5 µm and 3 µm, in particular 1.5 µm. Preferably, a protective layer 30 extends over the bottom electrode 28, in order to protect the bottom electrode 28 preventing oxidation thereof. For instance, the protective layer 30 is made of titanium or titanium nitride (TiN) and has a thickness, for example, ranging between 20 nm and 50 nm, in particular 30 nm. In other embodiments, the protective layer 30 could be omitted.

The HV capacitor 21 further comprises a dielectric multilayer 32, which extends over the protective layer 30. In embodiments in which the protective layer 30 is not present, the dielectric multilayer 32 extends over the bottom electrode 28.

The dielectric multilayer 32 comprises a first dielectric layer 34, for example made of tetraethyl orthosilicate (TEOS) or of silicon dioxide that can be obtained by any process of deposition on metal material. The first dielectric layer has a thickness, for example, ranging between 1 µm and 2 µm, in particular 1 µm.

Preferably, the dielectric multilayer 32 comprises a second dielectric layer 36, which extends over the first dielectric layer 34. The second dielectric layer 36 is made of a material different from that of the first dielectric layer 34, for example silicon nitride (Si₃Nₓ) or silicon oxynitride (SiOₓN_{y}) and has a thickness, for example, ranging between 1 µm and 2 µm, in particular 1 µm. Use of a number of depositions and a number of dielectric materials to form the dielectric multilayer 32 minimises the possibility of having structural defects that extend throughout the thickness of the dielectric multilayer 32. The second dielectric layer 36 may be omitted.

The dielectric multilayer 32 further comprises a third dielectric layer 38, which extends over the second dielectric layer 36. In embodiments in which the second dielectric layer 36 is not present, the third dielectric layer 38 extends over the first dielectric layer 34. According to an aspect of the present invention, the third dielectric layer 38 is made of polymeric material that can be laid in a conformable way, such as polyimide (PI), and has a thickness ranging between 10 µm and 30 µm, in particular 20 µm.

The dielectric multilayer 32 comprises a recess 40, which extends throughout its thickness, exposing a contact region 42 of the protective layer 30 and hence enabling electrical contact of the bottom electrode 28 of the HV capacitor 21, for example via wire bonding techniques. In embodiments in which the protective layer 30 is omitted, the contact region 42 extends directly over the bottom electrode 28.

The HV capacitor 21 further comprises a top electrode 46, which extends over the dielectric multilayer 32. The top electrode 46 is made of conductive material, such as gold, and has a thickness ranging between 0.1 µm and 0.2 µm, in particular 0.1 µm. Use of gold is preferable to facilitate wire bonding techniques. Preferably, the HV capacitor 21 further comprises a barrier layer 44, which extends between the top electrode 46 and the dielectric multilayer 32, in order to hinder the migration of atoms of the top electrode 46 towards the dielectric multilayer 32 that could favour undesired conductive paths between the top electrode 46 and the bottom electrode 28. The barrier layer 44 is made of metal material, such as titanium, and has a thickness, for example, ranging between 30 nm and 100 nm, in particular 50 nm.

The area of extension of the top electrode 46, in plan view in the plane xy, delimits an overlap region between the top electrode 46, the dielectric multilayer 32, and the bottom electrode 28, referred to in what follows as "active area 48". In other words, the HV capacitor 21 is a parallel-plate capacitor having an area limited by the area of extension of the top electrode 46. The area of extension of the top electrode 46, in plan view in the plane xy, ranges between 80 × 80 µm² and 200 × 200 µm², in particular 100 × 100 µm², and has a shape chosen from rectangular, circular, elliptical, polygonal, or polygonal with rounded corners.

The first dielectric layer 34 has a plurality of openings 50 in a region set between the active area 48 and the contact region 42. In the embodiments in which the second dielectric layer 36 is present, also this has a plurality of openings 50 aligned along the axis z to the plurality of openings 50 of the first dielectric layer 34. Consequently, the portion of the dielectric multilayer 32 included in the active area 48 has a constant thickness *t*ₒₓ, given by the sum of the thicknesses of the dielectric layers that make it up, whereas the portion of the dielectric multilayer 32 external to the active area 48 has a thickness ranging between a maximum value, corresponding to *t*ₒₓ, and a minimum value *t*ₘᵢₙ, corresponding to the thickness of just the third dielectric layer 38. In other words, the third dielectric layer 38 has depressions or grooves 37 at the openings 50. In particular, the third dielectric layer 38 has a top surface 38a that, in lateral cross-sectional view in the plane xz, has an undulated profile. Consequently, the length of the surface resistive path between the top electrode 46 and the contact region 42 increases as compared to the embodiment of a known type illustrated in Figure 1, wherein the dielectric layer does not have any grooves 37. Consequently, given the same surface resistance between the top electrode 46 and the contact region 42, the HV capacitors 21, 31 of the respective embodiments of Figures 2 and 3 are more compact than the HV capacitor 1 of a known type of Figure 1.

According to one embodiment, the openings 50 have a main direction of extension orthogonal to the direction of propagation of the current between the top electrode 46 and the contact region 42.

According to another embodiment, the main direction of extension of the openings 50 is not orthogonal to the direction of propagation of the current, and forms an angle ranging between 20° and 90° with the direction of propagation of the current between the top electrode 46 and the contact region 42.

In general, it is in any case expedient for the main direction of extension of the openings 50 not to be parallel to the direction of propagation of the current between the top electrode 46 and the contact region 42.

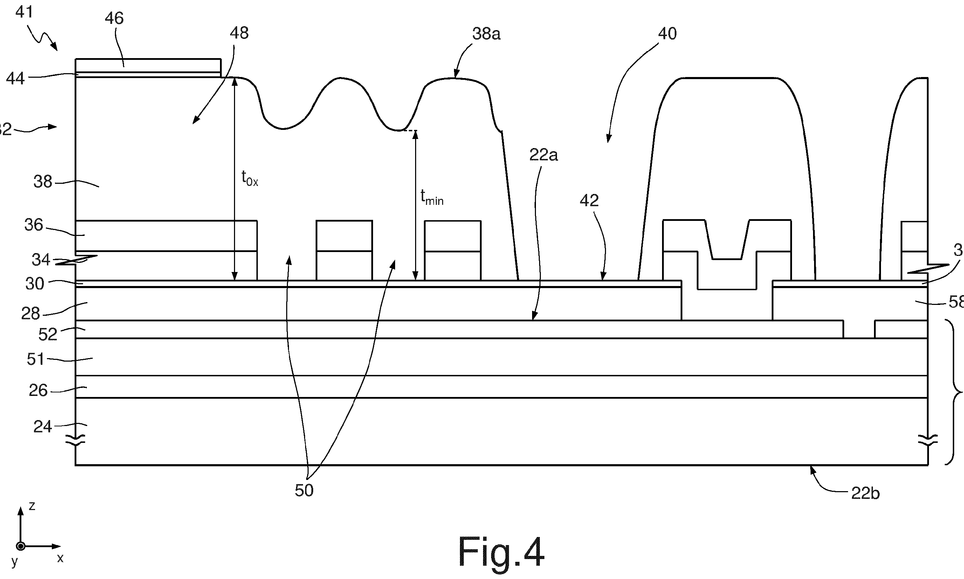

Figure 4 is a lateral cross-sectional view in the plane xz of a HV capacitor 41 according to a further embodiment of the present invention. The HV capacitor 41 differs from the HV capacitor 31 of Figure 3 due to the presence of further layers forming the substrate 22. Elements of the HV capacitor 41 that are common to the HV capacitor 31 are designated by the same reference numbers and are not described any further herein.

In particular, the substrate 22 of the HV capacitor 41 further comprises an electromagnetic shield layer 51, which extends over the field plate oxide layer 26 in order to protect the HV capacitor 41 from electromagnetic disturbances coming from outside. The electromagnetic shield layer 51 is made of conductive material, such as doped polysilicon or metal, and has a thickness, for example, ranging between 0.3 µm and 1.5 µm, in particular 0.5 µm.

The substrate 22 of the HV capacitor 41 further comprises an insulating layer 52, which extends over the electromagnetic shield layer 51. The insulating layer 52 is, for example, made of tetraethyl orthosilicate (TEOS) or of silicon dioxide that can be obtained by any process of deposition on metal material and has a thickness, for example, ranging between 0.5 µm and 0.7 µm, in particular 0.5 µm.

The insulating layer 52 functions as electrical insulating layer between the electromagnetic shield layer 51 and the bottom electrode 28. The electromagnetic shield layer 51 is electrically connected to an electrical terminal 58 through an opening of the insulating layer 52, enabling, in use, biasing of the electromagnetic shield layer 51 at a reference voltage. According to an aspect of the present invention, the electrical terminal 58 is formed starting from the same deposition of metal material as that of the bottom electrode 28 and creating an opening designed to insulate the bottom electrode 28 electrically from the electrical terminal 58. Preferably, the protective layer 30 also extends over the electrical terminal 58, in order to protect the electrical terminal 58 from oxidation phenomena.

In another embodiment (not illustrated), the high-resistivity substrate 24 and the field plate oxide layer 26 are replaced by a substrate made of insulating material, such as silicon dioxide (SiO₂), having a thickness, for example, ranging between 200 µm and 600 µm, in particular 300 µm. In this case, the electromagnetic shield layer 51 extends directly over the substrate made of insulating material.

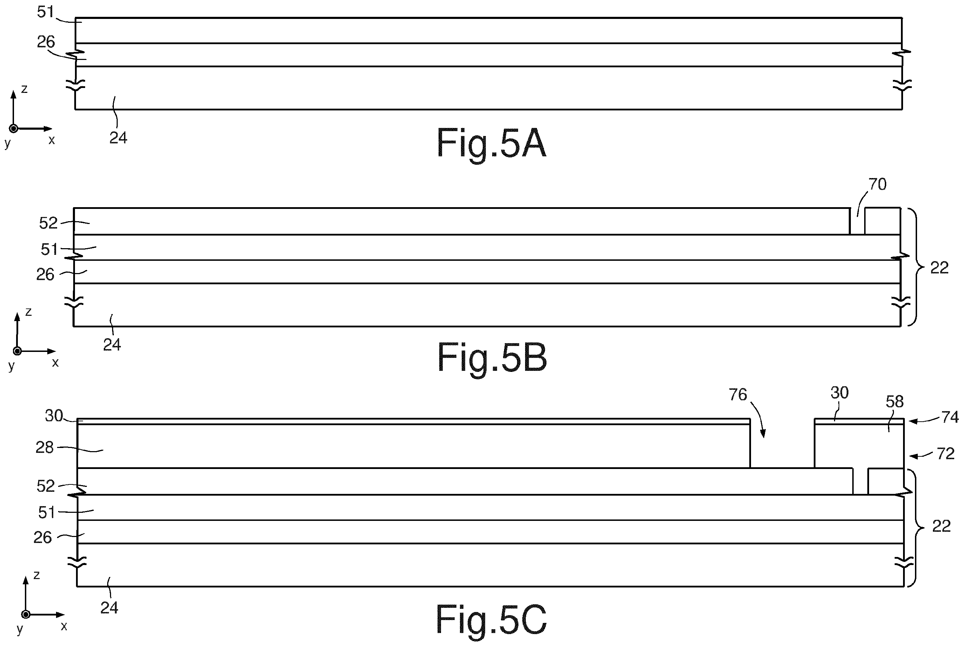

Described with reference to Figures 5A-5F are steps of a method for manufacturing the HV transistor 41 of Figure 4.

With reference to Figure 5A, a wafer is provided, which includes the high-resistivity substrate 24. This is followed by the step of forming the field plate oxide layer 26 on the high-resistivity substrate 24, for example via thermal growth of silicon dioxide. There then follows the step of forming the electromagnetic shield layer 51 on the field plate oxide layer 26, for example via deposition of doped polysilicon or a metal layer.

Then (Figure 5B), the step of forming the insulating layer 52 is carried out, for example via deposition of a TEOS layer and masked etching of the TEOS layer to form an opening 70, which extends throughout the thickness of the TEOS layer, in a region corresponding to the electromagnetic shield layer 51, where, in subsequent steps of the manufacturing method, an electrical contact with the electrical terminal 58 will be formed. The substrate 22 is thus formed.

Then (Figure 5C), the step of forming a first conductive layer 72 is carried out, for example via deposition of metal material, such as aluminium or copper on the insulating layer 52, simultaneously filling the opening 70 and hence forming an electrical contact between the electromagnetic layer 51 and the first conductive layer 72. Then, a second conductive layer 74 is formed on the first conductive layer 72, for example via deposition of metal material, such as titanium or titanium nitride (TiN).

This is followed by the step of forming an opening 76, which is laterally staggered with respect to the opening 70 and extends throughout the thickness of the first and second conductive layers 72, 74 in order to insulate electrically from one another two regions of the first conductive layer 72, which form the bottom electrode 28 and the electrical terminal 58, respectively. For instance, in plan view in the plane xy, the opening 76 entirely surrounds the electrical terminal 58. The second conductive layer 74 thus forms the protective layer 30. The opening 76 is formed, for example, via dry chemical etching.

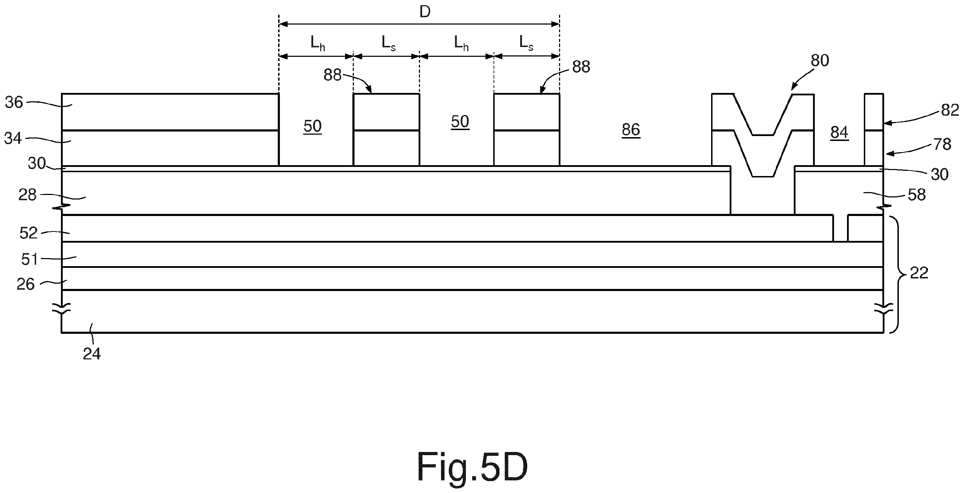

Then (Figure 5D), the step of forming the first dielectric layer 34 is carried out, for example via deposition of TEOS or SiO₂ obtained via CVD or PECVD. The first dielectric layer 34 fills the opening 76 entirely and extends over the protective layer 30. This is followed by the step of forming the second dielectric layer 36 on the first dielectric layer 34, made of a material different from that of the first dielectric layer 34, for example silicon nitride (Si₃Nₓ) or silicon oxynitride (SiOₓN_{y}).

There then follows the step of masked etching of the first and second dielectric layers 34, 36 in order to form a plurality of openings, which extend throughout the thickness of the first and second dielectric layers 34, 36, exposing respective regions of the protective layer 30.

The step of masked etching of the first and second dielectric layers 34, 36 comprises forming an opening 84 in a position corresponding to the electrical terminal 58, partially exposing the region of the protective layer 30 on the electrical terminal 58. Simultaneously, an opening 86 is formed in a region of the bottom electrode 28 where the contact region 42 will be formed, laterally staggered with respect to the opening 76 formed, in the step of Figure 5C, in the first conductive layer. Part of an electrical insulating structure 80 is thus formed between the bottom electrode 28 and the electrical terminal 58. Simultaneously, a plurality of openings 50 is formed, laterally staggered with respect to the opening 86. In other words, the opening 86 extends between the plurality of openings 50 and the electrical insulating structure 80. The openings 50 have an extension *L*ₕ, measured along the axis x, comprised, for example, between 20 µm and 30 µm, in particular 20 µm. In a non-limiting embodiment, the openings 50 are set at equal distances apart from one another. The number of openings 50 is, for example, between 2 and 20, for example 10. Consequently, each opening of the plurality of openings 50 is separated from an adjacent opening by a spacer 88 formed by the first and second dielectric layers 78, 82 and having an extension *L*ₛ, measured along the axis x, comprised, for example, between 5 µm and 20 µm, in particular 10 µm. Consequently, the extension D obtained from the sum of the extension *L*ₛ of each spacer 88 and the extension *L*ₕ of each opening 50 is between 55 µm and 1020 µm.

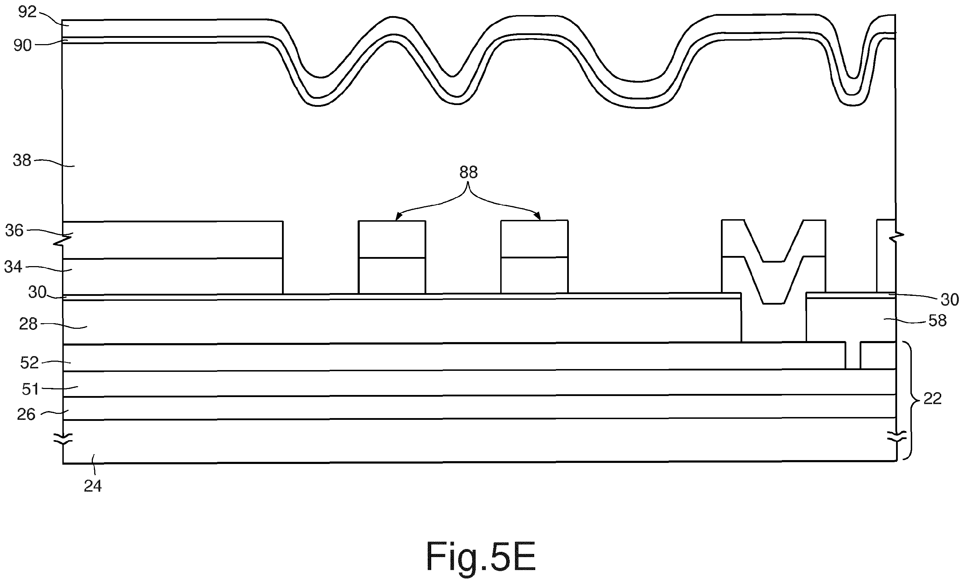

Next (Figure 5E), the step of forming the third dielectric layer 38 is carried out, for example, via spin coating of polyimide or another polymer capable of following in a conformable way the topography due to the spacers 88, also for thicknesses of the third dielectric layer 38 of some tens of micrometers. The third dielectric layer 38 fills the openings 50, 84, 86 of the first and second dielectric layers 34, 36 completely.

Then, the step of forming a third conductive layer 90 on the third dielectric layer 38 is carried out, for example, via sputtering of metal material, such as titanium.

This is then followed by the step of forming a fourth conductive layer 92 on the third conductive layer 90, for example via sputtering of metal material, such as gold.

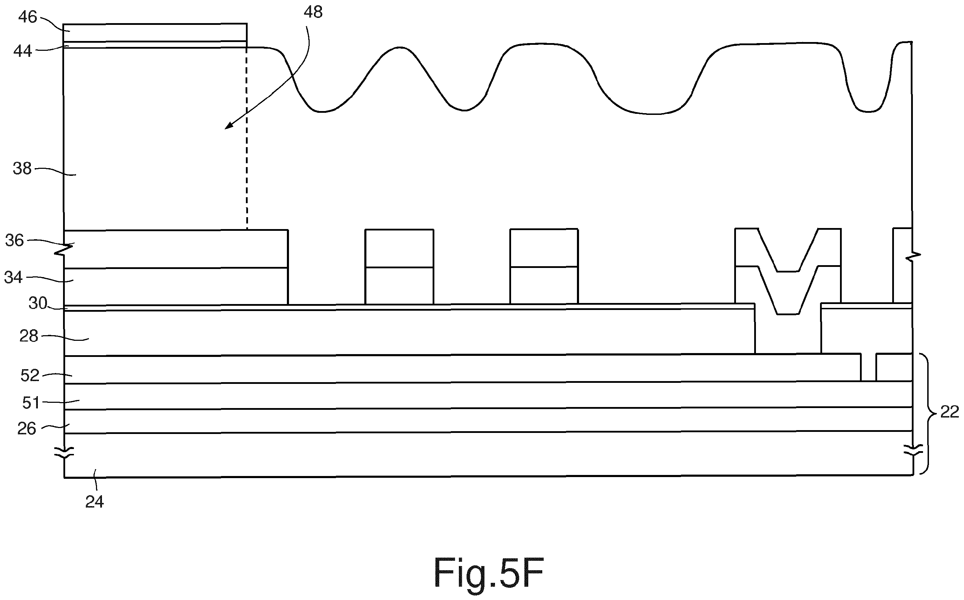

Next (Figure 5F), the step of masked etching of the third and fourth conductive layers 90, 92 is carried out, for example by wet or dry chemical etching, so as to remove the third and fourth conductive layers 90, 92 entirely, except for regions that, in plan view in the plane xy, delimit the active area 48 of the HV capacitor 41. The barrier layer 44 and the top electrode 46 are thus formed.

There then follows the step of masked etching of the third dielectric layer 38, to form the recess 40 (and expose the contact region 42) and another recess in a position corresponding to the electrical terminal 58, partially exposing the region of the protective layer 30 on the electrical terminal 58. The HV capacitor 41 of Figure 4 is thus obtained.

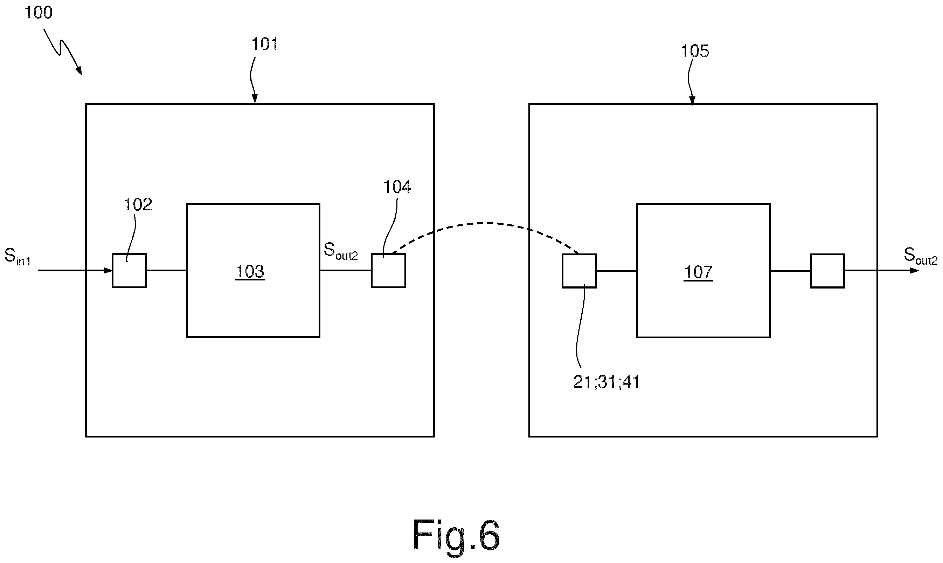

Figure 6 shows a block diagram of an electronic system 100 comprising a HV capacitor 21 or 31 or 41, according to the respective embodiment described previously. The electronic system 100 comprises a first electronic circuit 101 and a second electronic circuit 105, coupled to one another via the HV capacitor 21, 31, 41. In a non-limiting example, the first and second electronic circuits 101, 105 may be integrated on respective dies coupled to one another and housed in one and the same package.

An input terminal 102 of the first electronic circuit 101 is configured for receiving an input signal *S*ᵢₙ₁. The input terminal 102 is electrically coupled to a processing circuit 103 of the first electronic circuit 101. The processing circuit 103 is configured for processing the input signal *S*ᵢₙ₁ and generating a first output signal *S*ₒᵤₜ₁ at high frequency, on an output terminal 104 of the first electronic circuit 101. The second electronic circuit 105 houses the HV capacitor 21, 31, 41. The output terminal 104 of the first electronic circuit 101 is electrically coupled to the contact region 42 of the HV capacitor 21, 31, 41, for example by means of wire bonding techniques. The HV capacitor 21, 31, 41 is likewise electrically coupled to a processing circuit 107 of the second electrical circuit 105, configured for acquiring an output signal from the HV capacitor 21, 31, 41, processing said signal, and generating a second output signal *S*ₒᵤₜ₂. Electrical coupling between the first and second electronic circuits 101, 105 by means of the HV capacitor 21, 31, 41 enables transfer between the processing circuit 103 and the processing circuit 107 of the information associated with the first output signal *S*ₒᵤₜ₁ also in the case where there is a high difference of potential (for example, in the region of 10 kV) between the d.c. component of the first output signal *S*ₒᵤₜ₁ and the voltage accepted at input by the processing circuit 107 of the second electrical circuit 105.

From an examination of the characteristics of the invention described and illustrated herein, the advantages that it affords are evident.

For instance, obtaining a curvilinear surface profile of the third dielectric layer 38, by formation of spacers 88, enables an increase in the length, and hence resistance, of the lateral surface path between the top electrode 46 and the contact region 42 of the bottom electrode 28. Consequently, given the same surface resistance between the top electrode 46 and the contact region 42, the HV capacitors 21, 31, 41 of Figures 2, 3, 4 are more compact than the HV capacitor 1 according to the embodiment of a known type represented in Figure 1.

Moreover, the integration of an electromagnetic shield layer 51 in the substrate 22 enables reduction of the sensitivity of the HV capacitor 21 to electromagnetic disturbances coming from other components of the circuit in which it is integrated or coming from outside.

Finally, it is clear that modifications and variations may be made to the disclosure described and illustrated herein, without thereby departing from the sphere of protection of the present invention, as defined in the annexed claims.

## Claims

1. A capacitor (21; 31; 41), comprising:
a substrate (22);
a bottom plate, which extends over the substrate and includes a first conductive layer (28);
a top plate, which extends over the bottom plate and includes a second conductive layer (46);
a contact region (42), electrically coupled to the first conductive layer (28); and
a first dielectric layer (38), which extends between the bottom plate and the top plate,
the first dielectric layer (38) defining a surface path (38a) between the second conductive layer (46) and the contact region (42) and having a plurality of grooves (37) which increase the length of said surface path,
wherein the first dielectric layer (38) further includes a first dielectric region (48), which extends between the bottom plate and the top plate, and a second dielectric region which extends between the first dielectric region and the contact region (42), the second dielectric region being contiguous to the first dielectric region (48), said grooves (37) being formed in said second dielectric region,
said capacitor being **characterized by** further comprising a thickness-enhancement body (34, 36) of dielectric material, which extends over the bottom plate, and which extends continuously at the first dielectric region (48) between the bottom plate and the first dielectric layer (38) and which extends discontinuously at the second dielectric region between the bottom plate and the first dielectric layer, having openings (50) at the second dielectric region,
wherein the first dielectric layer (38) is of a polymeric material configured for reproducing, at the surface level, said openings (50) in a conformable way, to form said grooves (37).

2. The capacitor according to Claim 1, wherein said surface path includes a plurality of surface resistive electrical paths between the second conductive layer (46) and the contact region (42), and wherein the shortest resistive electrical path of said plurality of resistive electrical paths ranges between 60 µm and 1060 µm.

3. The capacitor according to Claim 1, wherein said surface path between the second conductive layer (46) and the contact region (42) includes a plurality of resistive electrical paths, which connect the second conductive layer (46) and the contact region (42), said grooves having a respective main direction of surface extension that forms an angle with the shortest resistive electrical path of said plurality of resistive electrical paths.

4. The capacitor according to Claim 3, wherein said angle is about 90°.

5. The capacitor according to anyone of the preceding claims, wherein said thickness-enhancement body (34, 36) is a multilayer comprising a second dielectric layer (34) including tetraethyl orthosilicate or silicon oxide and a third dielectric layer (36), including silicon nitride or silicon oxynitride, which extends over the second dielectric layer (34).

6. The capacitor according to any one of the preceding claims, wherein said first dielectric layer (38) is of polyimide.

7. The capacitor according to any one of the preceding claims, wherein said first dielectric layer (38) reaches a maximum height, tₒₓ, measured starting from said bottom plate and in a direction orthogonal to a plane of lie of the bottom plate, ranging between 12 µm and 32 µm and a minimum height, tₘᵢₙ, measured in said direction starting from said bottom plate, ranging between 8 µm and 28 µm,
wherein the first dielectric region has a uniform thickness in said orthogonal direction up to said maximum height,
and wherein said minimum height is reached in the second dielectric region in respective points of maximum depth of each groove (37).

8. A method for manufacturing a capacitor (21; 31; 41), comprising the steps of:
forming, on a substrate (22), a bottom plate, which includes a first conductive layer (28);
forming, on the substrate (22), a contact region (42) electrically coupled to the first conductive layer (28);
forming a first dielectric layer (38), on the bottom plate; and
forming a top plate, of conductive material (46), on the first dielectric layer (38),
the first dielectric layer (38) defining a surface path (38a) between the second conductive layer (46) and the contact region (42), and the step of forming the first dielectric layer (38) includes forming the first dielectric layer (38) in such a way to define a plurality of surface grooves (37) which increase the spatial extension of said surface path,
wherein the step of forming the first dielectric layer (38) includes the substeps of forming a first dielectric region (48) on the bottom plate and forming a second dielectric region, which is contiguous to the first dielectric region (48) and extends as far as the contact region (42), thus defining the surface path (38a) between the second conductive layer (46) and the contact region (42),
the step of forming the plurality of grooves (37) comprising forming the plurality of grooves (37) at the second dielectric region,
wherein the method comprises the steps of (i) forming a thickness-enhancement body (34, 36), of dielectric material, on the bottom plate; (ii) removing selective portions of the thickness-enhancement body (34, 36) to form openings (50) at the second dielectric region; (iii) depositing or spinning, in a conformable way on the thickness-enhancement body (34, 36) and within said openings (50), a polymeric material making up the first dielectric layer, wherein said polymeric material is configured for reproducing, at the surface level, said openings in a conformable way, to form said grooves.

9. The method according to Claim 8, wherein said surface path between the second conductive layer (46) and the contact region (42) includes a plurality of resistive electrical paths that connect the second conductive layer (46) and the contact region (42),
the step of forming the grooves including forming said grooves with a main surface direction of extension that forms an angle with the shortest resistive electrical path of said plurality of resistive paths.

10. The method according to Claim 8 or Claim 9, wherein the step of removing selective portions of the thickness-enhancement body (34, 36) in a discontinuous way comprises carrying out a masked etch of the thickness-enhancement body (34, 36) throughout its thickness to form a plurality of trenches.

11. The method according to anyone of claims 8-10, wherein the step of forming said thickness-enhancement body (34, 36) comprises the step of forming a multilayer, including the substeps of: forming a second dielectric layer (34) of tetraethyl orthosilicate or silicon oxide, and forming a third dielectric layer (36), of silicon nitride or silicon oxynitride, on the second dielectric layer (34).

12. The method according to any one of Claims 8-11, wherein the step of forming said first dielectric layer (38) includes depositing or spinning polyimide.

## Patentansprüche

1. Kondensator (21; 31; 41), Folgendes umfassend:
ein Substrat (22);
eine Bodenplatte, welche sich über das Substrat erstreckt und eine erste leitende Schicht (28) beinhaltet;
eine Kopfplatte, welche sich über die Bodenplatte erstreckt und eine zweite leitende Schicht (46) beinhaltet;
einen Kontaktbereich (42), elektrisch gekoppelt mit der ersten leitenden Schicht (28); und
eine erste dielektrische Schicht (38), welche sich zwischen der Bodenplatte und der Kopfplatte erstreckt,
wobei die erste dielektrische Schicht (38) eine Oberflächenbahn (38a) zwischen der zweiten leitenden Schicht (46) und dem Kontaktbereich (42) definiert und eine Vielzahl von Nuten (37) aufweist, welche die Länge der Oberflächenbahn vergrößern,
wobei die erste dielektrische Schicht (38) weiter einen ersten dielektrischen Bereich (48) beinhaltet, welcher sich zwischen der Bodenplatte und der Kopfplatte erstreckt, und einen zweiten dielektrischen Bereich, welcher sich zwischen dem ersten dielektrischen Bereich und dem Kontaktbereich (42) erstreckt, wobei der zweite dielektrische Bereich mit dem ersten dielektrischen Bereich (48) zusammenhängt, wobei die Nuten (37) in dem zweiten dielektrischen Bereich ausgebildet sind,
wobei der Kondensator **dadurch gekennzeichnet ist, dass** er weiter einen Dicke-Verstärkungs-Körper (34, 36) aus dielektrischem Material umfasst, welcher sich über die Bodenplatte erstreckt, und welcher sich kontinuierlich an dem ersten dielektrischen Bereich (48) zwischen der Bodenplatte und der ersten dielektrischen Schicht (38) erstreckt und welcher sich diskontinuierlich an dem zweiten dielektrischen Bereich zwischen der Bodenplatte und der ersten dielektrischen Schicht erstreckt, Öffnungen (50) in dem zweiten dielektrischen Bereich aufweisend, wobei die erste dielektrische Schicht (38) aus einem polymerischen Material besteht, dafür konfiguriert, um auf der Oberflächenebene die Öffnungen (50) auf eine konforme Weise zu reproduzieren, um die Nuten (37) auszubilden.

2. Generator nach Anspruch 1, wobei die Oberflächenbahn eine Vielzahl von elektrischen Oberflächenwiderstands-Bahnen zwischen der zweiten leitenden Schicht (46) und dem Kontaktbereich (42) umfasst, und wobei die kürzeste elektrische Oberflächenwiderstands-Bahn aus der Vielzahl von elektrischen Oberflächenwiderstands-Bahnen zwischen 60 µm und 1 060 µm liegt.

3. Generator nach Anspruch 1, wobei die Oberflächenbahn zwischen der zweiten leitenden Schicht (46) und dem Kontaktbereich (42) eine Vielzahl von elektrischen Oberflächenwiderstands-Bahnen umfasst, welche die zweite leitende Schicht (46) und den Kontaktbereich (42) verbinden, wobei die Nuten eine entsprechende Hauptrichtung von Oberflächenerstreckung aufweisen, die mit der kürzesten elektrischen Widerstandsbahn aus der Vielzahl von elektrischen Widerstandsbahnen einen Winkel bildet.

4. Generator nach Anspruch 3, wobei der Winkel um die 90° beträgt.

5. Kondensator nach einem der vorhergehenden Ansprüche, wobei der Dicke-Verstärkungs-Körper (34, 36) eine Mehrfachschicht ist, umfassend eine zweite dielektrische Schicht (34), Tetraethylorthosilicat oder Siliziumoxid beinhaltend, und eine dritte dielektrische Schicht (36), Siliziumnitrid oder Siliziumoxynitrid beinhaltend, welche sich über die zweite dielektrische Schicht (34) erstreckt.

6. Kondensator nach einem der vorhergehenden Ansprüche, wobei die erste dielektrische Schicht (38) aus Polyimid besteht.

7. Kondensator nach einem der vorhergehenden Ansprüche, wobei die erste dielektrische Schicht (38) eine maximale Höhe, *t*ₒₓ, erreicht, gemessen beginnend von der Bodenplatte und in eine Richtung orthogonal zu einer Liegeebene der Bodenplatte, zwischen 12 µm und 32 µm liegend, und eine Mindesthöhe, tₘᵢₙ, gemessen in der Richtung beginnend von der Bodenplatte, zwischen 8 µm und 28 µm liegend,
wobei der erste dielektrische Bereich eine einheitliche Dicke in der orthogonalen Richtung hinauf zu der maximalen Höhe aufweist,
und wobei die minimale Höhe in dem zweiten dielektrischen Bereich in entsprechenden Punkten von maximaler Tiefe jeder Rille (37) erreicht wird.

8. Verfahren zum Herstellen eines Kondensators (21; 31; 41), umfassend die folgenden Schritte:
Ausbilden einer Bodenplatte, welche eine erste leitende Schicht (28) beinhaltet, auf einem Substrat (22);
Ausbilden eines Kontaktbereichs (42), elektrisch gekoppelt mit der ersten leitenden Schicht (28), auf dem Substrat (22) ;
Ausbilden einer ersten dielektrischen Schicht (38) auf der Bodenplatte; und
Ausbilden einer Kopfplatte aus leitendem Material (46) auf der ersten dielektrischen Schicht (38),
wobei die erste dielektrische Schicht (38) einen Oberflächenpfad (38a) zwischen der zweiten leitenden Schicht (46) und dem Kontaktbereich (42) umfasst, und der Schritt des Ausbildens der ersten dielektrischen Schicht (38) das Ausbilden der ersten dielektrischen Schicht (38) auf eine solche Weise beinhaltet, dass eine Vielzahl von Oberflächennuten (37) definiert wird, welche die räumliche Ausdehnung des Oberflächenpfades erweitern,
wobei der Schritt des Ausbildens der ersten dielektrischen Schicht (38) die Unterschritte des Ausbildens eines ersten dielektrischen Bereichs (48) auf der Bodenplatte und das Ausbilden eines zweiten dielektrischen Bereichs umfasst, welcher mit dem ersten dielektrischen Bereich (48) zusammenhängt und sich so weit wie der Kontaktbereich (42) erstreckt, dadurch die Oberflächenbahn (38a) zwischen der zweiten leitenden Schicht (46) und dem Kontaktbereich (42) definierend,
wobei der Schritt des Ausbildens der Vielzahl von Nuten (37) das Ausbilden der Vielzahl von Nuten (37) an dem zweiten dielektrischen Bereich beinhaltet,
wobei das Verfahren die Schritte umfasst (i) des Ausbildens eines Dicke-Verstärkungs-Körpers (34, 36) aus dielektrischem Material auf der Bodenplatte; (ii) des Entfernens von selektiven Abschnitten des Dicke-Verstärkungs-Körpers (34, 36), um Öffnungen (50) in dem zweiten dielektrischen Bereich auszubilden; (iii) des Umpositionierens oder Drehens auf dem Dicke-Verstärkungs-Körpers (34, 36) eines polymerischen Materials, die erste dielektrische Schicht ausmachend, auf eine übereinstimmende Weise und innerhalb der Öffnungen (50),
wobei das polymere Material konfiguriert ist, um die Öffnungen auf der Oberflächenebene auf eine übereinstimmende Weise zu reproduzieren, um die Nuten auszubilden.

9. Verfahren nach Anspruch 8, wobei die Oberflächenbahn zwischen der zweiten leitenden Schicht (46) und dem Kontaktbereich (42) eine Vielzahl von elektrischen Oberflächenwiderstands-Bahnen beinhaltet, die die zweite leitende Schicht (46) und den Kontaktbereich (42) verbinden,
wobei der Schritt des Ausbildens der Nuten das Ausbilden der Nuten mit einer Hauptoberflächenerstreckungsrichtung beinhaltet, die einen Winkel mit der kürzesten elektrischen Oberflächenwiderstands-Bahn aus der Vielzahl von Oberflächenwiderstands-Bahnen bildet.

10. Verfahren nach Anspruch 8 oder Anspruch 9, wobei der Schritt des Entfernens selektiver Abschnitte des Dicke-Verstärkungs-Körpers (34, 36) auf eine diskontinuierliche Weise das Ausführen einer abgedeckten Ätzung des Dicke-Verstärkungs-Körpers (34, 36) über seine gesamte Dicke umfasst, um eine Vielzahl von Gräben auszubilden.

11. Verfahren nach einem der Ansprüche 8-10, wobei der Schritt des Ausbildens des Dicke-Verstärkungs-Körpers (34, 36) den Schritt des Ausbildens einer Mehrfachschicht umfasst, einschließlich der folgenden Unterschritte: Ausbilden einer zweiten dielektrischen Schicht (34) aus Tetraethylorthosilicat oder Siliziumoxid, und Ausbilden einer dritten dielektrischen Schicht (36) aus Siliziumnitrid oder Siliziumoxynitrid auf der zweiten dielektrischen Schicht (34).

12. Verfahren nach einem der Ansprüche 8-11, wobei der Schritt des Ausbildens der ersten dielektrischen Schicht (38) das Umpositionieren oder Drehen von Polyimid beinhaltend.

## Revendications

1. Condensateur (21 ; 31 ; 41) comprenant :
un substrat (22) ;
une plaque inférieure, qui s'étend sur le substrat et qui comporte une première couche conductrice (28) ;
une plaque supérieure, qui s'étend sur la plaque inférieure et qui comporte une deuxième couche conductrice (46) ;
une région de contact (42), couplée électriquement à la première couche conductrice (28) ; et
une première couche diélectrique (38) qui s'étend entre la plaque inférieure et la plaque supérieure,
la première couche diélectrique (38) définissant un chemin de surface (38a) entre la deuxième couche conductrice (46) et la région de contact (42) et comportant une pluralité de rainures (37) qui augmentent la longueur dudit chemin de surface,
dans lequel la première couche diélectrique (38) comprend en outre une première région diélectrique (48), qui s'étend entre la plaque inférieure et la plaque supérieure, et une deuxième région diélectrique qui s'étend entre la première région diélectrique et la région de contact (42), la deuxième région diélectrique étant contiguë à la première région diélectrique (48), lesdites rainures (37) étant formées dans ladite deuxième région diélectrique,
ledit condensateur étant **caractérisé en ce qu'**il comprend en outre un corps augmentant l'épaisseur (34, 36) en matériau diélectrique, qui s'étend sur la plaque inférieure, et qui s'étend de façon continue au niveau de la première région diélectrique (48) entre la plaque inférieure et la première couche diélectrique (38) et qui s'étend de façon discontinue au niveau de la deuxième région diélectrique entre la plaque inférieure et la première couche diélectrique, ayant des ouvertures (50) au niveau de la deuxième région diélectrique,
dans lequel la première couche diélectrique (38) est faite d'un matériau polymère configuré pour reproduire, au niveau de la surface, lesdites ouvertures (50) de manière concordante, pour former lesdites rainures (37).

2. Condensateur selon la revendication 1, dans lequel ledit chemin de surface comprend une pluralité de chemins électriques de surface résistifs entre la deuxième couche conductrice (46) et la région de contact (42), et dans lequel le chemin électrique résistif le plus court de ladite pluralité de chemins électriques résistifs est compris entre 60 µm et 1 060 µm.

3. Condensateur selon la revendication 1, dans lequel ledit chemin de surface entre la deuxième couche conductrice (46) et la région de contact (42) comprend une pluralité de chemins électrique résistifs, qui relient la deuxième couche conductrice (46) et la région de contact (42), lesdites rainures ayant une direction principale respective d'extension de surface qui forme un angle avec le chemin électrique résistif le plus court de ladite pluralité de chemins électriques résistifs.

4. Condensateur selon la revendication 3, dans lequel ledit angle vaut environ 90°.

5. Condensateur selon l'une quelconque des revendications précédentes, dans lequel ledit corps augmentant l'épaisseur (34, 36) est un corps multicouche comprenant une deuxième couche diélectrique (34) comportant de l'orthosilicate de tétraéthyle ou de l'oxyde de silicium et une troisième couche diélectrique (36), comportant du nitrure de silicium ou un oxynitrure de silicium, qui s'étend sur la deuxième couche diélectrique (34).

6. Condensateur selon l'une quelconque des revendications précédentes, dans lequel ladite première couche diélectrique (38) est en polyimide.

7. Condensateur selon l'une quelconque des revendications précédentes, dans lequel ladite première couche diélectrique (38) atteint une hauteur maximale, *t*ₒₓ, mesurée en partant de ladite plaque inférieure et dans une direction orthogonale à un plan de position de la plaque inférieure, comprise entre 12 µm et 32 µm et une hauteur minimale, tₘᵢₙ, mesurée dans ladite direction en partant de ladite plaque inférieure, comprise entre 8 µm et 28 µm,
dans lequel la première région diélectrique a une épaisseur uniforme dans ladite direction orthogonale jusqu'à ladite hauteur maximale,
et dans lequel ladite hauteur minimale est atteinte dans la deuxième région diélectrique en des points respectifs de profondeur maximale de chaque rainure (37).

8. Procédé de fabrication d'un condensateur (21 ; 31 ; 41) comprenant les étapes suivantes :
former, sur un substrat (22), une plaque inférieure, qui comporte une première couche conductrice (28) ;
former, sur le substrat (22), une région de contact (42) couplée électriquement à la première couche conductrice (28) ;
former une première couche diélectrique (38) sur la plaque supérieure ; et
former une plaque supérieure, en matériau conducteur (46), sur la première couche diélectrique (38),
la première couche diélectrique (38) définissant un chemin de surface (38a) entre la deuxième couche conductrice (46) et la région de contact (42), et l'étape de formation de la première couche diélectrique (38) comprend le fait de former la première couche diélectrique (38) de telle façon à définir une pluralité de rainures de surface (37) qui augmentent l'étendue spatiale dudit chemin de surface,
dans lequel l'étape de formation de la première couche diélectrique (38) comprend les sous-étapes consistant à former une première région diélectrique (48) sur la plaque inférieure et à former une deuxième région diélectrique, qui est contiguë à la première région diélectrique (48) et qui s'étend jusqu'à la région de contact (42), en définissant ainsi le chemin de surface (38a) entre la deuxième couche conductrice (46) et la région de contact (42),
l'étape de formation de la pluralité de rainures (37) comprenant le fait de former la pluralité de rainures (37) au niveau de la deuxième région diélectrique,
dans lequel le procédé comprend les étapes suivantes : (i) former un corps augmentant l'épaisseur (34, 36), en matériau diélectrique, sur la plaque inférieure ; (ii) retirer des parties sélectives du corps augmentant l'épaisseur (34, 36) pour former des ouvertures (50) au niveau de la deuxième région diélectrique ; (iii) déposer ou filer, de façon concordante sur le corps augmentant l'épaisseur (34, 36) et dans lesdites ouvertures (50), un matériau polymère qui forme la première couche diélectrique, dans lequel ledit matériau polymère est configuré pour reproduire, au niveau de la surface, lesdites ouvertures de manière concordante, pour former lesdites rainures.

9. Procédé selon la revendication 8, dans lequel ledit chemin de surface entre la deuxième couche conductrice (46) et la région de contact (42) comprend une pluralité de chemins électriques résistifs qui relient la deuxième couche conductrice (46) et la région de contact (42),
l'étape de formation des rainures comprenant le fait de former lesdites rainures avec une direction d'extension de surface principale qui forme un angle avec le chemin électrique résistif le plus court de ladite pluralité de chemins résistifs.

10. Procédé selon la revendication 8 ou 9, dans lequel l'étape de retrait de parties sélectives du corps augmentant l'épaisseur (34, 36) de façon discontinue comprend l'exécution d'une gravure avec cache du corps augmentant l'épaisseur (34, 36) sur toute son épaisseur pour former une pluralité de tranchées.

11. Procédé selon l'une quelconque des revendications 8 à 10, dans lequel l'étape de formation dudit corps augmentant l'épaisseur (34, 36) comprend l'étape consistant à former un corps multicouche, comportant les sous-étapes suivantes : former une deuxième couche diélectrique (34) en orthosilicate de tétraéthyle ou oxyde de silicium, et former une troisième couche diélectrique (36), en nitrure de silicium ou oxynitrure de silicium, sur la deuxième couche diélectrique (34).

12. Procédé selon l'une quelconque des revendications 8 à 11, dans lequel l'étape de formation de ladite première couche diélectrique (38) comprend le dépôt ou le filage de polyimide.
